(19) Europäisches Patentamt / European Patent Office / Office européen des brevets

(11) **EP 4 552 219 B1**

(12) **EUROPEAN PATENT SPECIFICATION**

(45) Date of publication and mention
of the grant of the patent:
**18.03.2026 Bulletin 2026/12**

(21) Application number: **23738549.7**

(22) Date of filing: **05.07.2023**

(51) International Patent Classification (IPC):
$H03M\ 7/30$ (2006.01)     $H03M\ 7/40$ (2006.01)

(52) Cooperative Patent Classification (CPC):
**H03M 7/3068; H03M 7/40**

(86) International application number:
**PCT/EP2023/068550**

(87) International publication number:
**WO 2024/008798 (11.01.2024 Gazette 2024/02)**

(54) **UNIVERSAL MULTI-SENSOR DATA COMPRESSION**

UNIVERSELLE MEHRSENSORDATENKOMPRESSION

COMPRESSION UNIVERSELLE DE DONNÉES MULTI-CAPTEURS

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **06.07.2022 EP 22183338**

(43) Date of publication of application:
**14.05.2025 Bulletin 2025/20**

(73) Proprietor: **Aarhus Universitet**
**8000 Aarhus C (DK)**

(72) Inventors:
• **KULDEEP, Gajraj**
  **8000 Aarhus C (DK)**
• **ZHANG, Qi**
  **8000 Aarhus C (DK)**

(74) Representative: **Høiberg P/S**
**Adelgade 12**
**1304 Copenhagen K (DK)**

(56) References cited:
• LIESNER ACEVEDO ET AL: "Partial Data Replication as a Strategy for Parallel Computing of the Multilevel Discrete Wavelet Transform", 13 September 2009, PARALLEL PROCESSING AND APPLIED MATHEMATICS, SPRINGER BERLIN HEIDELBERG, BERLIN, HEIDELBERG, PAGE(S) 51 - 60, ISBN: 978-3-642-14389-2, XP019146926

• HSIEH JUI-HUNG ET AL: "Wavelet-Based Quality-Constrained ECG Data Compression System Without Decoding Process", IEEE MULTIMEDIA, IEEE SERVICE CENTER, NEW YORK, NY, US, vol. 27, no. 2, 31 March 2020 (2020-03-31), pages 33 - 45, XP011793229, ISSN: 1070-986X, [retrieved on 20200612], DOI: 10.1109/MMUL.2020.2983690

• LORIO F ET AL: "Analysis of data compression methods for power quality events", IEEE POWER ENGINEERING SOCIETY GENERAL MEETING 2004, IEEE, PISCATAWAY, NJ, USA, 6 June 2004 (2004-06-06), pages 504 - 509, XP010756504, ISBN: 978-0-7803-8465-1, DOI: 10.1109/PES.2004.1372851

• MARK FONTENOT: "A wavelets introduction", JOURNAL OF COMPUTING SCIENCES IN COLLEGES, CONSORTIUM FOR COMPUTING SCIENCES IN COLLEGES, P.O. BOX 329 EVANSVILLE IN 47702 USA, vol. 17, no. 3, 1 February 2002 (2002-02-01), pages 290 - 296, XP058153688, ISSN: 1937-4771

**Description**

The present disclosure relates to signal compression devices, systems and methods for compression of signals.

**Background**

Internet of Things (IoT) have demonstrated an unprecedented potential to digitalize and automate diverse industrial processes and to provide intelligent services. On the one hand, with fast deployment of huge amount of IoT devices, the ever-increasing sensor data volume has posed many challenges in data acquisition, communication and storage. On the other hand, with the advancement of Microelectromechanical systems (MEMS) technology, multiple miniaturized sensors can be integrated into an IoT device. Integrating more sensors in a single device brings new opportunities for novel applications, while it poses challenges on the computation, memory and energy resource of IoT device. To enable sustainable growth of IoT ecosystem, efficient sensor data acquisition, transmission and storage solution is the key.

Uncompressed signals can consume considerable storage and transmission resources. Some of the main advantages of data compression are reduction in data storage, data transmission time and energy, and communication bandwidth. Because compressed signals require significantly less storage capacity and transmission resource than uncompressed signals, significant cost savings can be achieved. Data compression methods can be categorized into lossless compression or lossy compression. Lossy data compression methods provide better compression gain than the lossless compression methods at the cost of reconstructed signal quality. In general, the reconstructed signal quality depends on the level of compression, i.e. high compression ratio often leads to low signal quality. Oftentimes the user cannot get back original data after compression.

IoT devices generate a massive amount of data that needs to be transmitted to and processed at the data aggregator or edge/cloud. However, most of the connected IoT devices have constraints in memory, computation power, energy and bandwidth. Therefore, the state-of-the-art IoT systems call for lightweight computation and an efficient signal compression method.

Data compression systems and methods are described in the prior art, including the approach by Liesner Acevedo et al. [1], which discloses a strategy for parallel computing of the multilevel discrete wavelet transform using partial data replication to reduce communication overhead. Hsieh Jui-Hung et al. [2] describe a wavelet-based, quality-constrained ECG data compression system that avoids the need for full decoding. Lorio et al. [3] present an analysis of various data compression methods applied to power quality events. Fontenot [4] provides an introduction to wavelets and, for example, includes a short explanation of the Haar wavelet transform.

**Summary**

Considering the prior art described above, it is a purpose of the present disclosure to overcome above-mentioned challenges.

The invention is defined by the appended claims.

The present approach relates in a first aspect to a method for compression of a signal $x$, of length $N_1$, comprising data. The method comprises the step of at least for a first level of decomposition, transforming the signal based on a first sparse matrix $A_1$, of size $N_1 \times N_1$ formed by an invertible matrix $\Phi_{d1}$, representing a divisor-based signal decomposition for a first divisor $d_1$ to obtain a first vector $s_1$ of transformation coefficients, wherein $s_1 = A_1 x$, and wherein the first vector $s_1$ comprises an initial component $v^1$ and detail components $w_1^1, w_2^1, \ldots, w_{d_1-1}^1$. The method further comprises the step of at least for a second level of decomposition, transforming the initial component based on a second sparse matrix $A_2$, of size $N_2 \times N_2$, where $N_2 = \dfrac{N_1}{d_1}$, formed by an invertible matrix $\Phi_{d2}$, representing a divisor-based signal decomposition for a second divisor $d_2$, to obtain a second vector $s_2$ of transformation coefficients wherein $s_2 = A_2 v^1$, and wherein the second vector $s_2$ comprises an initial component $v^2$ and detail components $w_1^2, w_2^2, \ldots, w_{d_2-1}^2$. The method further comprises the step of quantizing the transformation coefficients of the second vector of transformation coefficients $v^2$, $w_1^2, w_2^2, \ldots, w_{d_2-1}^2$ and detail components of the first vector $w_1^1, w_2^1, \ldots, w_{d_1-1}^1$, to obtain a quantized transformation vector. Then the signal is compressed based on the quantized transformation vector.

The invertible matrices, $\Phi_{d1}$ and $\Phi_{d2}$, may for example be provided by discrete cosine bases. Advantageously, the present disclosure leverages divisor-based signal decomposition, preferably with a discrete cosine transform. First, a divisor is selected based on the signal length, and the chosen divisor is used to construct a transformation matrix. Then, the transformation matrix can be applied to the signal to reduce time and frequency redundancy. Finally, on the transformed signal, an entropy coding can be applied to reduce coding redundancy.

The present approach solves the above-mentioned drawbacks of signal compression and provides first of all a signal compression method that is efficient in terms of memory, computation power, and energy. Due to reduction in resource usage, such as energy consumption, the present approach can offer a cost effective solution for signal compression while maintaining a high quality of the signal after decompression. The present approach offers an improved compression approach, by reducing the calculations needed for data compression. Generally, quantization and inverse quantization are very costly in terms of calculations required. A great advantage of the presently disclosed approach is that the memory, computation power and energy consumption can be reduced significantly. Because, with the above-mentioned sparse matrix composition, calculations, i.e., the number of multiplications, can be reduced. Consequently, it is possible to reduce the energy required for signal compression. The number of multiplications are reduced because of the divisor based multi-resolution decomposition, i.e., two level decomposition. For example, in general wavelet transforms are applied on radix-2 scale, whereas with the presently disclosed approach the above-mentioned sparse matrix can be applied on radix-d scale, where d is a divisor.

The state-of-the-art lossy compression methods are often designed and tailored for a particular signal type. For instance, JPEG is designed for images. For most Internet of Things (IoT) applications, an IoT device generates multi-modality sensor data, instead of a single type of signal. For instance, in e-Health applications, a smart watch collects photoplethysmogram (PPG), accelerometer, temperature and others. Due to lack of a unified data compression encoder in the conventional setting, it leads to poor utilization of constrained resources (e.g. energy, memory) at IoT devices. An important aspect of the presently disclosed approach can be that it better exploits both time and frequency redundancy in the signals due to the multi-level decomposition. The multi-level decomposition can be more generalized than the other existing decompositions, e.g., wavelet decomposition, and can better segregate frequency bands for both stationary and non-stationary signals. Therefore, the proposed approach can be applied to various types of signals, namely universality. This implies that the present approach can receive signals from one or more sensors. A wide range of data types can be received from a wide range of sensors in real-time and compressed.

The present disclosure relates in a second aspect to a computer program for compressing a signal comprising data and having instructions, which, when executed by a processing unit, cause the processing unit to carry out the steps of the presently disclosed method.

The present approach relates in a third aspect to a device, such as a wearable device, autonomous vehicle, smart meter, industrial monitoring device, or the like, having one or multiple sensors, wherein the device comprises a processing unit configured to execute the steps of the presently disclosed method. Advantageously, the proposed approach can be used for a variety of applications, such as e-Heath, Industry 4.0, industrial monitoring, process automation, structure health monitoring, predictive maintenance, smart agriculture, autonomous driving, and many others in real time. The device can be any device that can be connected wirelessly to a network and has the ability to transmit and communicate sensor data. The present novel data compression solution can achieve a superior compression performance for a wide range of sensor data types.

The signals of a variety of sensors can be received without the need for identifying the type of the sensor. The number of signals can be compressed separately by means of the above described multi-level decomposition to obtain a number of transformation vectors. After, entropy coding can be applied to a combination of the number of transformation vectors.

Many of the state-of-the-art lossy compression methods mostly require large signal samples to achieve a decent compression. However, in many applications data compression needs to be performed on a small number of signal samples due to device resource constraints or latency requirements in applications. Because of the above discussed properties, the proposed method works for small (e.g. 256) as well as large (e.g. greater than 256) signal lengths.

The presently disclosed compression approach can therefore achieve superior compression performance for a wide range of sensor data types while not compromising from the quality of the compressed data. The present approach can achieve reconstructed signal quality close to that of near lossless compression. The superior data compression can be provided for various types of signals, for example, images, audio, electrocardiogram (ECG), accelerometer, magnetometer, etc.

As a result, the present approach enables an efficient data compression, which can significantly reduce the transmission cost, via a reduction in transmission energy, communication bandwidth, thereby extending device battery lifetime, reducing the interference in a dense network, as well as reducing edge/cloud storage cost. The present approach relates in a fourth aspect to a system comprising memory and compression and/or a processing unit, such as the device as described above.

## Description of the drawings

The present disclosure will in the following be described in greater detail with reference to the accompanying drawings:

Figure 1: 1a illustrates an example electrocardiogram (ECG) signal of length 256 samples, 1b shows an exemplary illustration of a transformed signal of 1a, after applying the presently disclosed approach first time (one level decomposition) with divisor 8, 1c shows an exemplary illustration of a transformed signal after applying Wavelet transform three times (three level decomposition) on the ECG signal with symlet filter of length 8.

Figure 2: 2a shows an example image, 2b shows an exemplary illustration of level one decomposition of image using divisor 8, 2c shows an exemplary illustration of level two decomposition of image using divisor 2.

Figure 3 shows an example block diagram of one-dimensional compression method according to the present disclosure.

Figure 4 shows an example block diagram of two-dimensional compression method according to the present disclosure.

Figure 5 shows a plot illustrating an application of the presently disclosed compression approach on a real data signal. The graph shows two curves, wherein one curve shows the real measured data from an electrocardiogram measuring device and the other curve shows the result of the same electrocardiogram data after being compressed (and decompressed) by an example of the herein disclosed compression approach.

## Detailed description

### *Level-one signal decomposition*

The divisors of the present approach are preferably selected based on the signal length, and the chosen divisor is used to construct a transformation matrix. In an embodiment, the signal lengths $N_1$ and $N_2$ are divisible by the divisors $d_1$ and $d_2$, respectively. In a further embodiment, the first divisor and the second divisor are positive integers.

A sparse matrix $A$, can be constructed by means of an invertible matrix $\Phi_d$.

In an embodiment, $A_1$ is formed by the invertible divisor matrix $\Phi_{d1}$ of size $d_1 \times d_1$ and wherein the matrix $\Phi_{d1}$ comprises one low-pass filter, e.g. in the form of the initial component, and high-pass filters, e.g. in the form of the detail components.

In an embodiment, $A_2$ is formed by the invertible divisor matrix $\Phi_{d2}$ of size $d_2 \times d_2$ and wherein the matrix $\Phi_{d2}$ comprises one low-pass filter, e.g. in the form of the initial component and high-pass filters, e.g. in the form of the detail components.

Thus, in general, $A$ is a matrix of size $N \times N$ and formed by an arbitrary but fixed invertible matrix $\Phi_d$ of size $d \times d$. For a given $d$, the invertible matrix $\Phi_d$ can be represented as,

$$\Phi_d = \begin{bmatrix} \phi_1 \\ \phi_2 \\ . \\ . \\ \phi_d \end{bmatrix}$$

where vector $\phi_i$ is the i-th row of the matrix $\Phi_d$.

The matrix A can be constructed in the following manner. First, by extending the row vectors of $\Phi_d$ up to length $N$ by appending $N - d$ zeros after that, shifted by $kd$, where $k = 0; 1; 2 ... ; N/d - 1$. Thus, in an embodiment, the row vectors of $\Phi_{d1}$ is extended up to a signal length $N_1$ by appending $N_1 - d_1$ zeros. This means that each of the row vectors can be extended up to the signal length $N_1$ by appending $N_1 - d_1$ zeros. In a further embodiment, the row vectors of $\Phi_{d1}$ are shifted by $kd_1$ for each row, wherein $k = 0, 1, 2, ..., N_1/d_1 - 1$.

For example, the matrix constructed using the first row vector $\phi_1$ can be given as,

$$\begin{bmatrix} \phi_1 & 0_{1\times d} & 0_{1\times d} & \cdots & \cdots & 0_{1\times d} \\ 0_{1\times d} & \phi_1 & 0_{1\times d} & \cdots & \cdots & 0_{1\times d} \\ . & . & . & . & . & . \\ \\ 0_{1\times d} & 0_{1\times d} & 0_{1\times d} & & & \phi_1 \end{bmatrix}_{\frac{N}{d}\times N}$$

This shifting operation results in $N/d$ orthogonal vectors for each row vector $\phi_i$.

Therefore, the total number of row vectors of the matrix A is $N$ for the given matrix $\Phi_d$.

Matrix $A$ can be represented as,

$$A = \begin{bmatrix} \boldsymbol{\phi}_1 & \mathbf{0}_{1\times d} & \mathbf{0}_{1\times d} & \cdots & \mathbf{0}_{1\times d} \\ \mathbf{0}_{1\times d} & \boldsymbol{\phi}_1 & \mathbf{0}_{1\times d} & \cdots & \mathbf{0}_{1\times d} \\ \vdots & & \vdots & & \\ \mathbf{0}_{1\times d} & \mathbf{0}_{1\times d} & \mathbf{0}_{1\times d} & \cdots & \boldsymbol{\phi}_1 \\ \boldsymbol{\phi}_2 & \mathbf{0}_{1\times d} & \mathbf{0}_{1\times d} & \cdots & \mathbf{0}_{1\times d} \\ \mathbf{0}_{1\times d} & \boldsymbol{\phi}_2 & \mathbf{0}_{1\times d} & \cdots & \mathbf{0}_{1\times d} \\ \vdots & & \vdots & & \\ \mathbf{0}_{1\times d} & \mathbf{0}_{1\times d} & \mathbf{0}_{1\times d} & \cdots & \boldsymbol{\phi}_2 \\ \vdots & \vdots & \vdots & \vdots & \vdots \\ \boldsymbol{\phi}_d & \mathbf{0}_{1\times d} & \mathbf{0}_{1\times d} & \cdots & \mathbf{0}_{1\times d} \\ \mathbf{0}_{1\times d} & \boldsymbol{\phi}_d & \mathbf{0}_{1\times d} & \cdots & \mathbf{0}_{1\times d} \\ \vdots & & \vdots & & \\ \mathbf{0}_{1\times d} & \mathbf{0}_{1\times d} & \mathbf{0}_{1\times d} & \cdots & \boldsymbol{\phi}_d \end{bmatrix}$$

This matrix can be invertible from construction. Hence, the signal x, of length

*N* comprising data can be represented by $\boldsymbol{s} = \boldsymbol{Ax}$.

In an embodiment, $\Phi_{d1}$ and $\Phi_{d2}$ are provided by discrete cosine bases.

For example, if for any integer, $d \geq 2$, the entries such as $d_{km}$, the $k^{th}$ row and $m^{th}$ column, of the matrix $\Phi_d$ are defined as,

$$d_{km} = \cos\left(\frac{\pi k(2m+1)}{2d}\right),$$

where $0 \leq k \leq d$ - 1 and $0 \leq m \leq d$ - 1.

A few examples of $\Phi_d$ are shown in the following.

For $d = 2$, the matrix, $\Phi_2$, is

$$\Phi_2 = \begin{bmatrix} 1 & 1 \\ 0.7071 & -0.7071 \end{bmatrix}.$$

**For** d = 3, **the** matrix, $\Phi_3$, is

$$\Phi_3 = \begin{bmatrix} 1 & 1 & 1 \\ 0.8660 & 0 & -0.8660 \\ 0.5 & -1 & 0.5 \end{bmatrix}.$$

*Multi-level decomposition*

The above example presents level one multiresolution decomposition. The proposed approach can however also be applied on multiple levels.

For a given signal *x*, of length *N,* let $N_1 = N$, and there is $N_{i+1} = N_i/d_i$, $N_i$ has divisor $d_i$. For the divisor, $d_1$, the decomposed signal $\boldsymbol{s}_1 = \boldsymbol{A}_1\boldsymbol{x}$ can be represented as,

$$s_1 = v^1 \oplus w_1^1 \oplus \ldots \oplus w_{d_1-1}^1$$

where $\boldsymbol{v}^1$ is an initial component, $\boldsymbol{w}_i^1 \text{s}$ are detail components for divisor $d_1$, and $\oplus$ is the direct sum. Now the component $\boldsymbol{v}^1$ can be further decomposed into $\boldsymbol{s}_2 = \boldsymbol{A}_2\boldsymbol{v}^1$ using divisor $d_2$ and it can be represented as,

$$s_2 = v^2 \oplus w_1^2 \oplus \ldots \oplus w_{d_1-1}^2$$

where $v^2$ **is** an initial component and $w_i^2 s$ are detail components for divisor $d_2$.

Similarly for the $k^{th}$ divisor $d_k$ the decomposition $s_k = A_k v^{k-1}$ is given as,

$$s_k = v^k \oplus w_1^k \oplus .... \oplus w_{d_k-1}^k$$

Using all $k$ divisors, the decomposed signal y can be represented as,

$$y = v^k \oplus w_1^k \oplus .... \oplus w_{d_k-1}^k \oplus w_1^{k-1} \oplus ....\oplus w_{d_{k-1}-1}^{k-1} \oplus \ ... \ \oplus w_1^1 \oplus \ ... \oplus w_{d_1-1}^1.$$

The initial component $v^1$ can be seen as a high-pass filter, whereas the detail components can be seen as low-pass filters.

As stated above the application of matrix $A_1$ on a one-dimensional signal typically results in one initial component and $d_1 - 1$ detail components. The probability distribution of the multi-level decomposition of any positive valued signal has bimodal distribution because of the one initial component and rest detail components. To make this distribution unimodal, mean value (average value) of the initial component can be calculated and subtracted from the initial component. For positive signals the quantization can be performed after subtracting a mean value from the initial component of the final decomposed transformation coefficients.

Furthermore, in an embodiment, the quantization is adaptive such that the transformation coefficients can be quantized using one or more thresholds. The quantization can be adaptive based on the signal characteristics. With the presently disclosed approach, the signal can be transformed in orthogonal subspaces that can be quantized using a different threshold, which could provide higher compression. For example, adaptive sub-band quantization can be used.

*Two-dimensional data compression*

Until here one-dimensional data compression approach has been described. The compression algorithm can also be applied for two-dimensional signal compression. In an embodiment, the signal is an image signal. Advantageously, the proposed approach can be a separable transform, which can be applied to image signals by first applying on rows then on columns. This implies that, in an embodiment, the method comprises the step of applying at least the first sparse matrix and at least the second sparse matrix on each dimension of a multi-dimensional signal, such as on each dimension of an image. In a further embodiment, the first sparse matrix and the second sparse matrix are applied first on rows and then on columns, respectively.

For example for a given image signal $X$, of size $H \times W$, the data can be represented by $S = A_1 X B_1^T$ where the matrix $A_1$ is a first row sparse matrix, and $B_1$ is a column sparse matrix, which can be constructed using divisors for $H$ and $W$, respectively. This process can be repeated on the first level initial component. According to the present disclosure, the width and height may be same or different for an image signal. For multi-dimensional signals a common divisor may be used for each dimension if the length of each dimension is equal, the divisor can also be different for each dimension and/or each level of decomposition.

For example, for an image, for the first level, the image height may have a divisor $d_{1,1}$ and image width may have a divisor $d_{1,2}$ and $d_{1,1} \neq d_{1,2}$. Similarly, for the second level, the image height and image width of the initial component after the first level decomposition of an image can use different or same divisors $d_{2,1}$ and $d_{2,2}$. In an embodiment therefore, the method comprises the step of applying at least the first sparse matrix and at least the second sparse matrix on at least one dimension of a multi-dimensional signal, and applying at least a third sparse matrix based on a third-divisor $d_{1,2}$ and at least a fourth sparse matrix based on a fourth-divisor $d_{2,2}$ on at least a second dimension of a multi-dimensional signal. In an embodiment, first the first-level decomposition is applied for all dimensions and afterwards the second-level decomposition is applied for all dimensions. This implies that for an image signal, first the first sparse matrix and the third sparse matrix based on divisors $d_{1,1}$ and $d_{1,2}$, respectively are applied on the two dimensions of the image. After, for the second level decomposition, the second sparse matrix and the fourth sparse matrix based on divisors $d_{2,1}$ and $d_{2,2}$, respectively are applied.

In an embodiment, the method comprises the step of, for the first level decomposition, applying the first sparse matrix and the third sparse matrix based on divisors $d_{1,1}$ and $d_{1,2}$, on at least a first dimension and a second dimension of the two dimensional signal, respectively. In a further embodiment, the method comprises the step of, for the second level decomposition, applying the second sparse matrix and the fourth sparse matrix based on divisors $d_{2,1}$ and $d_{2,2}$, on at least a first dimension and a second dimension of the two dimensional signal, respectively.

For two-dimensional data, at any one level decomposition there are one initial component and $d_1^2 - 1$ detail components if image width and image height have a common divisor $d_1$. In an embodiment therefore, the application of matrix $\boldsymbol{A}_1$ on a two-dimensional signal results in one initial component and $d_1^2 - 1$ detail components. Decomposed and quantized image can be vectorized in one of the following ways:

- Column/row stacking of the whole decomposed and quantized image.
- Zig-zag decomposition of the whole decomposed and quantized image.
- Column/row stacking of the each decomposed and quantized subspace.
- Zig-zag decomposition of the each decomposed and quantized subspace.

*Universality*

In an embodiment, the signal is received from one or more sensors. In an embodiment, the data signal is any natural signal such that the signal can be collected by a sensor. In an embodiment therefore, the signal is a time-series signal. The present approach leverages the multi-level decomposition which is a more generalized decomposition and can better segregate frequency bands compactly. In an embodiment, the transform can provide multiresolution at any radix, i.e, the divisor of the signal length, in addition, the radix of the transform can be selected based on the signal characteristics. Therefore, a wide range of signals can be compressed with superior performance using the proposed approach.

In an embodiment, the method comprises the step of receiving data in real time. In an embodiment, the signal represents real-time sensor data collected by one or more sensors, such as an audio sensor, magnetometer, accelerometer, electrocardiogram sensor, image sensor, or photoplethysmography sensor. The signal can comprise a plurality of sensor data acquired from a plurality of sensors configured such that each of the sensor data is transformed and quantized simultaneously. In an embodiment, the signal is received from a plurality of sensors.

In an embodiment, the method comprises the step of concatenating the quantized transformation vectors of one or more sensors into a single vector. In a further embodiment, entropy coding is applied on the single vector. In a further embodiment, the method comprises the step of applying an entropy coding technique, for example, arithmetic coding or Huffman coding, on the single vector such the signal from a plurality of sensors are compressed.

Additionally, in an embodiment, the method comprises the step of decompression to obtain reconstructed signals by performing entropy decoding, de-quantization, and inverse transformation for a level-wise decomposition.

Additionally, the present disclosure relates an IoT device, such as a wearable device, autonomous vehicle, smart meter, industrial monitoring device, having multiple sensors, wherein the IoT device comprises a processing unit configured to execute the steps of any one of the present approach. A processor may include a single processor or a plurality of processors. A processor may include a central processing unit (CPU) that carries out the instructions of the computer program.

The device can comprise at least one sensor for measuring data. The device can have access to an available dataset. The device can further comprise communication interface. In an embodiment, the device can be configured to transmit the compressed data. The device can collect and compress data and the compressed data can be transmitted through the communication interface. In an embodiment, the device can be further configured to store the compressed data.

Finally, the present disclosure relates a signal compression system, comprising a memory device and a compression unit, such as an IoT device. In a further embodiment, the system can be configured to execute the method of the present approach. The memory can store instructions or a computer program for executing the presented approach.

**Detailed description of the drawings**

The presently disclosed approach provides an effective compression. In order to exemplify advantages of the present approach, the present approach can for example be compared with the Wavelet transform. For filter length of *d*, both the present approach and Wavelet transform require (*d* - 1)*N* additions and *dN* multiplications. For this case the length of initial component is *N/d* and the length of combined detail components is (*d* - 1)*N/d* for the current approach. Similarly for the Wavelet transform the length of initial component is *N/2* and the detail component is also *N/2*, because for the Wavelet transform *d* = 2. When *d* > 2, the present approach takes the same number of additions and multiplications as Wavelet transform but provide higher compact representation.

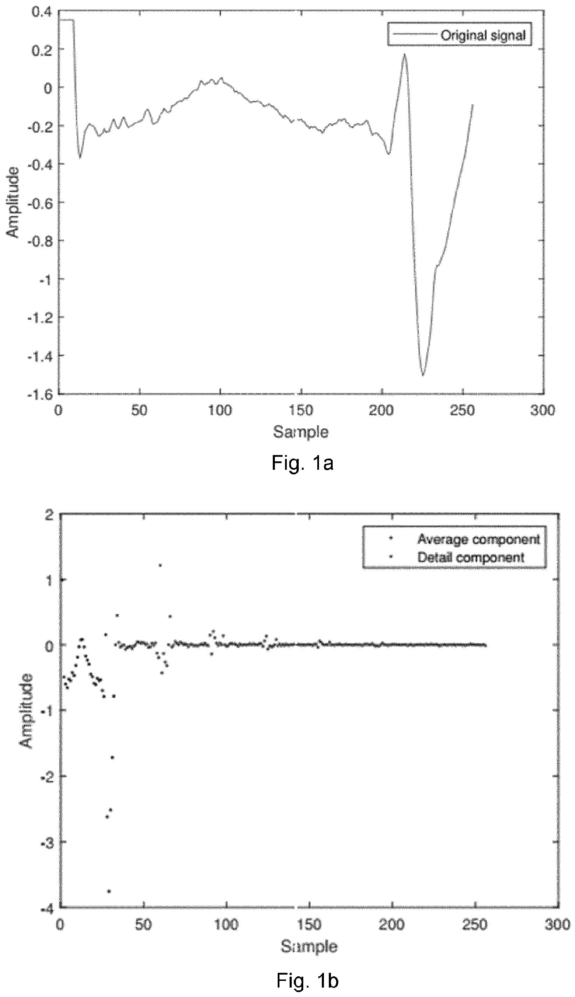

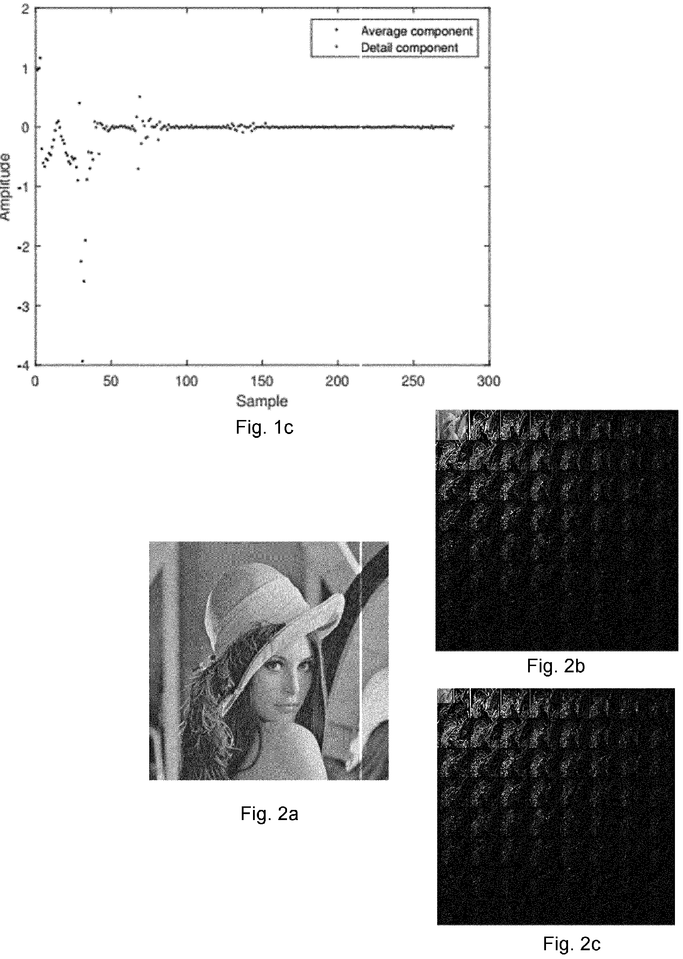

This effect can be observed from Fig. 1. Fig. 1a illustrates an example ECG signal of length 256. These are simulated for N = 256 and filter length 8. Fig. 1b shows an exemplary illustration of a transformed signal of Fig. 1a, after applying the presently disclosed approach for the first time (one level decomposition) with divisor 8. Fig. 1c shows an exemplary illustration of a transformed signal after applying Wavelet transform three times (three level decomposition) on the ECG signal with symlet filter of length 8. It can be observed that to have the same effect as the present approach, the Wavelet transform has to be applied three times. That will result in 7*(256+128+64) additions and 8*(256+128+64) multiplications for Wavelet transform, whereas the present approach will only require 7*256 additions and 8*256 multiplications. Because the number of additions and multiplications are reduced; the computational cost related to data compression such as energy consumption can be reduced. Furthermore, a high quality data compression can be achieved within a shorter processing time.

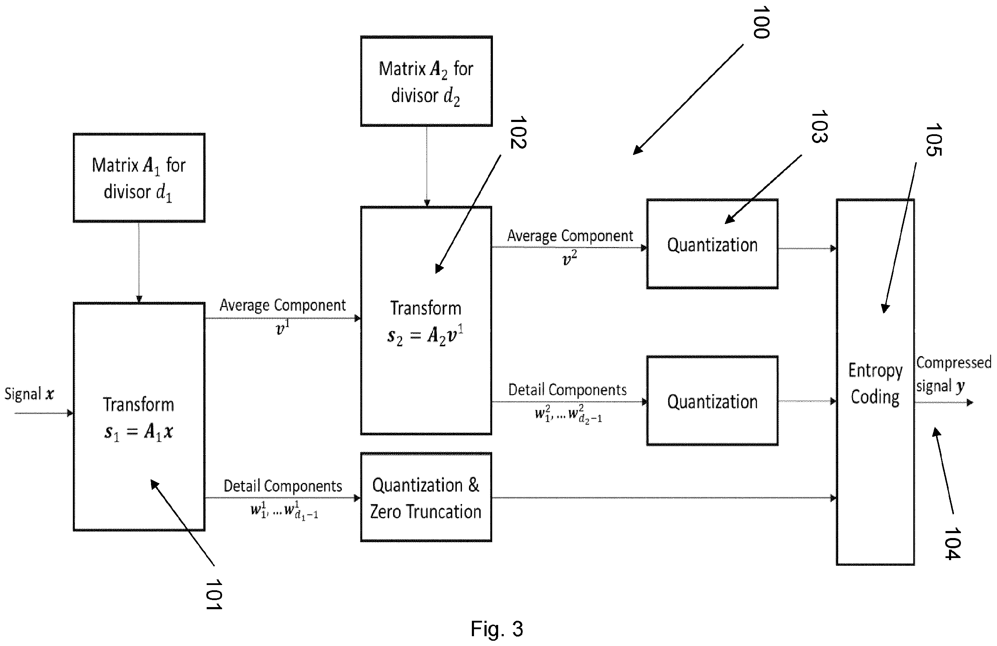

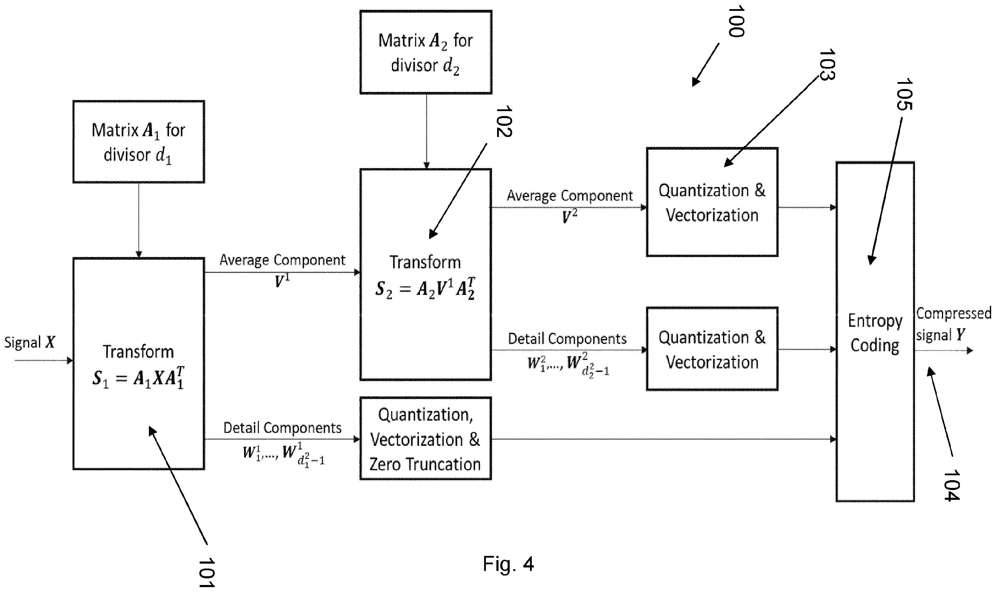

For image, at any one level decomposition there are one initial component and $d^2$ - 1 detail components if image width and image height have common divisor $d$. An application of the present approach for two level decomposition of an image is shown in Fig. 2. Original image of size $512 \times 512$ is shown in Fig. 2a. Decomposition of the image is shown in Fig. 2b and Fig. 2c for divisors 8 and 2, respectively. The compression algorithm for one-dimensional signal compression is shown in an exemplary block diagram in Fig. 3. The compression algorithm for two-dimensional signal compression is shown in an exemplary block diagram in Fig. 4.

Fig. 3 shows the compression steps for one-dimensional signals. First, signal is transformed using the first divisor then the initial component from the transformed signal is again transformed using the second divisor. Finally, all detail components and second level initial component are quantized and encoded using entropy coding. The encoded signal is represented as **y.**

Fig. 4 shows the compression steps for two-dimensional signals with same size in both dimensions. First, a two-dimensional signal is transformed using the first divisor by applying the transformation matrix on both dimensions, i.e., for an image this transformation is applied on rows and columns. The first step will generate one initial component and detail components. The initial component in this case is two-dimensional. Then, the initial component is transformed using the second divisor on both dimensions. After that, all the detail components from the first and second level are vectorized and quantized. Finally entropy coding is applied on the quantized vector.

For entropy coding, the presented example uses arithmetic coding. For one-dimensional algorithm, the quantization step, $Q$, with some positive value $\theta$ for the second level initial component is performed as,

$$Q(v^2) = \left\lfloor v^2 \frac{1}{\theta\sqrt{d_1 d_2}} + 0.5 \right\rfloor \text{ where } v^2 \text{ is the initial component.}$$

The quantization step for the second level detail components is given as $Q(w_i^2) = \left\lfloor w_i^2 \frac{\sqrt{2}}{\theta\sqrt{d_1 d_2}} + 0.5 \right\rfloor$

where $w_i^2$ is the $i^{th}$ second level detail component.

For the first level detail components, the quantization step can be performed using,

$Q(w_i^1) = \left\lfloor w_i^1 \frac{\sqrt{2}}{\theta\sqrt{d_1}} + 0.5 \right\rfloor$ where $w_i^1$ is the $i^{th}$ first level detail component.

For two-dimensional algorithm shown in Fig. 4, the quantization step with some positive value $\theta$ for the second level initial component is performed as, $Q(V^2) = \left\lfloor V^2 \frac{1}{\theta d_1 d_2} + 0.5 \right\rfloor$ where $V^2$ is the initial component.

The quantization step for the second level detail components is given as $Q(W_i^2) = \left\lfloor W_i^2 \frac{2}{\theta d_1 d_2} + 0.5 \right\rfloor$ where

$W_i^2$ is the $i^{th}$ second level detail component.

For the first level detail components, the quantization step can be performed using,

$$Q(W_i^1) = \left\lfloor W_i^1 \frac{2}{\theta d_1} + 0.5 \right\rfloor \text{ where } W_i^1 \text{ is the } i^{th} \text{ first level detail component.}$$

**Example**

An example of a compression and decompression of raw electrocardiogram data according to the presently disclosed approach is provided in the following pages. The raw data comprises a vector of $N_1 = 512$ entries, wherein each entry is the electrocardiogram measured data at a given point in time. The presently disclosed compression method will be applied to the raw data and a decompression is performed afterwards to obtain a reconstructed signal in order to compare with the original signal. In this example, all measured numbers have been rounded to two decimal digits in order to reduce the length of the tables. On the other hand, the operations performed on the raw data and the compression method have been performed with the maximum accuracy provided by the raw data generator device, in this case an electrocardiogram device. The compression method may be applied to data comprising a number of decimal digits, such as two, five, ten or more.

The parameters for the transformation of the raw data are:

$$N_1 = 512, \ d_1 = 8, d_2 = 4, \theta = 10$$

The original raw signal of the electrocardiogram values measured by a device is $x$ = [995; 995; 995; 995; 995; 995; 995; 995; 1000; 997; 995; 994; 992; 993; 992; 989; 988; 987; 990; 993; 989; 988; 986; 988; 993; 997; 993; 986; 983; 977; 979; 975; 974; 972; 969; 969; 969; 971; 973; 971; 969; 966; 966; 966; 966; 967; 965; 963; 967; 969; 969; 968; 967; 963; 966; 964; 968; 966; 964; 961; 960; 957; 952; 947; 947; 943; 933; 927; 927; 939; 958; 980; 1010; 1048; 1099; 1148; 1180; 1192; 1177; 1128; 1058; 991; 951; 937; 939; 950; 958; 959; 957; 955; 958; 959; 961; 962; 960; 957; 956; 959; 955; 957; 958; 957; 958; 959; 958; 958; 955; 953; 957; 959; 963; 960; 960; 958; 956; 957; 956; 955; 953; 953; 956; 958; 958; 958; 956; 954; 959; 959; 958; 958; 957; 957; 956; 958; 956; 954; 953; 954; 955; 958; 960; 957; 958; 955; 958; 957; 957; 955; 955; 953; 956; 956; 957; 958; 954; 954; 955; 957; 957; 957; 954; 953; 953; 955; 955; 957; 954; 952; 952; 952; 951; 952; 950; 947; 950; 952; 953; 952; 949; 949; 951; 951; 952; 952; 951; 950; 953; 958; 959; 959; 957; 956; 961; 964; 964; 966; 965; 966; 967; 969; 973; 974; 974; 971; 973; 975; 978; 975; 975; 973; 973; 976; 974; 973; 975; 973; 974; 974; 971; 972; 972; 971; 970; 971; 972; 969; 968; 966; 969; 970; 972; 968; 968; 967; 969; 969; 971; 970; 967; 966; 968; 969; 967; 968; 964; 964; 963; 965; 964; 962; 962; 963; 965; 967; 967; 966; 965; 962; 966; 965; 964; 963; 962; 959; 962; 964; 966; 962; 959; 958; 961; 964; 963; 962; 960; 958; 959; 961; 962; 963; 963; 962; 964; 963; 966; 964; 964; 963; 963; 966; 968; 965; 963; 961; 963; 965; 966; 968; 970; 969; 969; 970; 974; 974; 973; 979; 980; 983; 984; 983; 981; 978; 980; 979; 979; 979; 978; 977; 976; 977; 980; 982; 983; 975; 967; 967; 964; 962; 958; 958; 959; 961; 960; 961; 959; 956; 955; 956; 956; 954; 955; 953; 958; 957; 958; 960; 955; 953; 956; 958; 959; 958; 954; 951; 952; 948; 939; 935; 929; 922; 917; 923; 941; 964; 992; 1021; 1071; 1122; 1168; 1199; 1212; 1205; 1175; 1122; 1057; 1002; 970; 946; 934; 929; 933; 939; 946; 946; 947; 946; 948; 948; 948; 945; 947; 947; 947; 949; 945; 942; 942; 944; 945; 946; 943; 945; 947; 949; 946; 946; 943; 942; 942; 946; 946; 945; 943; 941; 944; 942; 943; 942; 941; 942; 944; 944; 945; 946; 943; 942; 946; 946; 947; 947; 942; 943; 945; 946; 949; 946; 945; 942; 944; 946; 946; 947; 943; 941; 941; 944; 945; 943; 941; 940; 940; 942; 941; 939; 940; 937; 938; 938; 940; 938; 934; 933; 934; 937; 935; 934; 933; 930; 932; 933; 934; 933; 930; 929; 932; 934; 935; 936; 937; 936; 942; 945; 950; 951; 952; 951; 956; 959; 961; 960; 958; 958; 960; 962; 964; 964; 960; 960; 961; 963; 963; 965; 960; 958; 963; 962; 964; 964; 960; 959; 962; 963]

The signal $x$ is then transformed into the decomposed signal $s_1 = A_1 x$. The signal $s_1$ is generated after applying the matrix $A_1$ described in the previous sections, which is constructed using $\Phi_{d1}$ on the original signal. The matrix $A_1$ has been normalized using $d_1$.

[**2814,28; 2811,46; 2796,25; 2787,06; 2746,4; 2732,26; 2734,03; 2713,52; 2670,74; 3175,62; 2737,56; 2711,4; 2707,87; 2709,28; 2703,98; 2707,51; 2706,1; 2704,68; 2703,62; 2704,33; 2698,67; 2689,13; 2690,19; 2702,21; 2730,14; 2755,24; 2754,89; 2748,88; 2741,45; 2738,98; 2732,26; 2728,02; 2724,48; 2720,95; 2718,12; 2725,54; 2727,31; 2743,57; 2772,21; 2766,56; 2750,65; 2712,46; 2702,56; 2707,16; 2662,26; 2811,1; 3231,48; 2666,85; 2678,52; 2672,86; 2673,22; 2668,97; 2668,27; 2671,45; 2673,92; 2669,33; 2658,72; 2648,82; 2638,92; 2640,69; 2689,13; 2717,76; 2718,83; 2721,3;** 0; 8,22; 1,36; 21,05; 0,5; 3,08; 4,48; 18,16; -24,09; -140,45; 62,35; -3,38; -1,71; -4,56; 5,89; -0,58; 2,61; -3,39; 2,51; -0,52; -0,55; 2,14; -0,26; -7,13; -5,63; - 3,12; 0,34; 3,13; -0,13; 0,51; 5,19; -4,64; 3,87; 2,78; -0,38; -1,12; 2,41; -6,42; -4,21; 3,37; 21,54; 0,11; -1,08; -0,71; 30,44; -187,01; 168,37; 9,99; 0,42; 2,43; 1,89; 2,42; -3,75; -0,38; 2,38; 2,02; 2,34; 4,49; 0,79; -7,48; -13,29; -4,44; -0,13; 1,78; 0; 1,58; -3,73; 0,69; 4,19; -0,38; -1,27; -3,35; 39,27; -100,4; 74,32; -3,73; 0,96; 5,03; 0; 1,42; -0,65; -4,62; 2,42; 3,08; -2,42; 1,69; 3,08; -5,58; - 0,27; 2,42; -0,54; 0,84; 2,88; -3,73; 0,65; 0,92; -3,27; 2,5; 4,73; -1,77; 0; 1,31; -7,97; -0,19; -0,77; -3,81; 2,34; 4,38; -6,42; 44,46; -111,93; 28,58; -0,92; 5,11; -5,58; -1,27; 1,77; -4,96; -0,19; 4,19; -2,12; 1,19; 3,15; -1,77; -0,92; 4; -4,84; 1,12; 0; 2,55; -2,19; -2,95; 2,33; 2,89; -2,27; 3,65; -9,31; 18,02; 38; 3; -0,09; 2,73; 1,65; -3,67; 1,68; 1,1; -1,23; 1,65; 2,89; -2,71; 1,95; 1,82; -2,33; 0,6; 0,47; 0,86; 3,77; 1,88; -1,92; 2,66; 0,75; -5,88; 0,77; 1,03; -5,11; -2,74; -0,13; -0,3; -4,34; 1,63; - 1,83; 2,21; 0,32; -23,78; 2,69; 13,54; -1,37; -0,46; -1,1; -3,2; 1,07; 0,77; -4,32; 1,54; 0,89; -4,52; 1,39; 0,53; -5,23; 1,66; 2,79; -3,56; 0; -0,71; 2,47; -3,18; -0,71; 0; -0,35; -1,06; 2,83; -17,68; 15,2; -0,35; 0,35; -2,47; 1,41; 0; -1,41; 0,71; 0,35; -1,06; -0,35; 2,12; 0,35; 1,77; 0; -3,18; 1,41; 1,06; - 1,41; 0,35; 0,71; 0; 0; -0,71; -0,71; 0,35; -0,71; -1,41; -1,77; 1,06; -4,24; -0,71; -0,71; -2,47; -1,41; 13,79; -14,14; 4,6; 1,41; -2,12; -0,35; -1,77; 1,06; 0,71; 0,35; -2,83; 0,71; 0,71; -1,41; 0,35; 0,71; -0,35; -0,71; 1,06; 0; 1,63; 1,37; -1,02; 1,13; 1,08; 0,36; 0,07; -2,4; 8,11; 10,58; 1,23; -1,93; -0,16; 0,01; 0,88; 0,45; 0,38; 0,46; -1,2; 0,66; 0,24; -0,75; 1,04; -0,53; 0,48; 2,37; -1,13; 1,14; -0,37; - 0,15; 0,58; 2,38; 0; -0,51; -0,27; -0,51; 0,72; -1,12; -0,03; 1,06; 1,27; 0,3; -2,03; 3,5; -3,81; -2,27; 4,52; 0,78; -1,59; 0,64; 0,34; -0,49; -0,51; -0,16; -0,24; 1,62; 0,66; -0,28; 1,45; 0,16; -0,09; 0,17; 2,15; 0; 0,11; 1,16; -2,96; -0,97; 0,92; -2,15; 0,24; 0,57; -5,87; 4,81; 1,16; -2,31; -1,7; 0; -2,12; 0,27; -1,91; -0,62; -0,89; 0,62; -1,47; -0,89; 0,4; -0,65; -0,62; -1,31; -0,73; -0,43; 1,16; -0,27; 0,38; 1,35; 0,49; 0,34; 0,35; 0; -0,54; -1,68; 0,46; 1,85; 0,05; -1,74; -1,43; 1,13; 1,1; -4,15; 1,56; -0,38; -0,59; 0,4; -2,15; -0,35; 2,82; 0,46; -0,97; -1,42; 1,04; 0,22; 0,35; -0,38; -0,51; 1,24; -0,08; 0; - 0,47; -1,41; 1,94; -0,26; -0,11; 1,46; 0,58; -1,55; 1,35; 1,89; 0,71; -0,91; 1,49; -0,78; 0,67; -1,07; 1,07; 1,58; -1,03; -1,19; 0,13; 0,25; -0,55; -1,27; 1,48; -0,23; -0,82; 1,86; 0,76; -2,09; 0,1; 1,34; 0,83; 0,07; 2,03; 0,9; 0,89; -0,69; -0,2; -0,52; -0,85; 2,1; -0,05; -0,34; 1,59; -0,55; 2,22; 1,52; -0,6; -1,51; 0,54; 0,27; 0,07; 1,77; -0,68; 0,32; -0,07; 1,18; 0,46; 1,47; 0,14; -1,47; 0,12]

The elements of $s_1$ marked in **bold** before are the first initial component, $v^1$, of size $\dfrac{N_1}{d_1}$ and the rest are the detail components. The signal $s_1$ is then transformed into the signal $s_2 = A_2v^1$, wherein $v^1$ is the first initial component from the signal $s_1$ shown above. The signal $s_2$ is given below and is generated after applying the matrix $A_2$, which is constructed using $\Phi_{d2}$, on the initial component $v^1$. The matrix $A_2$ has been normalized using $d_2$. The resulting signal $s_2$ is:

[5.604,53; 5.463,11; 5.647,66; 5.414,32; 5.409,37; 5.390,10; 5.494,57; 5.470,35; 5.444,55; 5.504,83; 5.436,41; 5.685,85; 5.346,79; 5.341,48; 5.293,58; 5.423,51; 21,90; 21,00; 91,97; 1,67; 1,44; -2,60; -12,15; 10,59; 0,07; -33,39; 31,09; -116,76; 6,14; -1,36; 14,46; -21,31; -3,18; - 3,18; -265,52; 1,06; 1,06; 10,78; -15,56; -0,88; 5,48; -10,96; 21,39; -356,74; 0,71; -3,89; 5,83; - 13,08; -2,57; 10,05; -297,17; -3,37; -0,21; -0,26; -5,30; -0,75; -2,13; 8,09; 5,30; 273,38; 2,81; 1,33; -1,59; -8,01]

Subsequently the step of quantizing the transformation coefficients of the second vector of transformation coefficients $v^2$ and detail components of the first vector is performed, to obtain a quantized transformation vector. The obtained quantized transformation vector is:

[560; 546; 565; 541; 541; 539; 549; 547; 544; 550; 544; 569; 535; 534; 529; 542; 2; 2; 9; 0; 0; 0; -1; 1; 0; -3; 3; -12; 1; 0; 1; -2; 0; 0; -27; 0; 0; 1; -2; 0; 1; -1; 2; -36; 0; 0; 1; -1; 0; 1; -30; 0; 0; 0; -1; 0; 0; 1; 1; 27; 0; 0; 0; -1; 0; 1; 0; 2; 0; 0; 0; 2; -2; -14; 6; 0; 0; 0; 1; 0; 0; 0; 0; 0; 0; 0; 0; 0; -1; -1; 0; 0; 0; 0; 0; 1; 0; 0; 0; 0; 0; 0; -1; 0; 0; 2; 0; 0; 0; 3; -19; 17; 1; 0; 0; 0; 0; 0; 0; 0; 0; 0; 0; 0; -1; -1; 0; 0; 0; 0; 0; 0; 0; 0; 0; 0; 0; 4; -10; 7; 0; 0; 1; 0; 0; 0; 0; 0; 0; 0; 0; -1; 0; 0; 0; 0; 0; 0; 0; 0; 0; 0; 0; 0; 0; 0; -1; 0; 0; 0; 0; -1; 4; -11; 3; 0; 1; -1; 0; 0; 0; 0; 0; 0; 0; 0; 0; 0; 0; 0; 0; 0; 0; 0; 0; -1; 2; 4; 0; 0; 0; 0; 0; 0; 0; 0; 0; 0; 0; 0; 0; 0; 0; 0; 0; 0; 0; 0; 0; 0; -1; 0; 0; -1; 0; 0; 0; 0; 0; 0; 0; 0; -2; 0; 1; 0; 0; 0; 0; 0; 0; 0; 0; 0; -1; 0; 0; 0; 0; 0; 0; 0; 0; 0; 0; 0; -2; 2; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 1; -1; 0; 0; 0; 0; 0; 0; 0; 0; 0; 0; 0; 0; 0; 0; 0; 0; 0; 0; 0; 0; 0; 1; 1; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; -1; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0]

Now, the quantized signal is de-quantized, as explained previously. The reconstructed transformed signal is:

**[5600; 5460; 5650; 5410; 5410; 5390; 5490; 5470; 5440; 5500; 5440; 5690; 5350; 5340; 5290; 5420; 20; 20; 90; 0; 0; 0; -10; 10; 0; -30; 30; -120; 10; 0; 10; -20; 0; 0; -270; 0; 0; 10; -20; 0; 10; -10; 20; -360; 0; 0; 10; -10; 0; 10; -300; 0; 0; 0; -10; 0; 0; 10; 10; 270; 0; 0; 0; -10**; 0; 10; 0; 20; 0; 0; 0; 20; -20; -140; 60; 0; 0; 0; 10; 0; 0; 0; 0; 0; 0; 0; 0; -10; -10; 0; 0; 0; 0; 0; 10; 0; 0; 0; 0; 0; 0; -10; 0; 0; 20; 0; 0; 0; 30; -190; 170; 10; 0; 0; 0; 0; 0; 0; 0; 0; 0; 0; 0; -10; -10; 0; 0; 0; 0; 0; 0; 0; 0; 0; 0; 0; 40; -100; 70; 0; 0; 10; 0; 0; 0; 0; 0; 0; 0; 0; -10; 0; 0; 0; 0; 0; 0; 0; 0; 0; 0; 0; 0; 0; 0; -10; 0; 0; 0; 0; -10; 40; -110; 30; 0; 10; -10; 0; 0; 0; 0; 0; 0; 0; 0; 0; 0; 0; 0; 0; 0; 0; 0; -10; 20; 40; 0; 0; 0; 0; 0; 0; 0; 0; 0; 0; 0; 0; 0; 0; 0; 0; 0; 0; 0; 0; 0; 0; -10; 0; 0; -10; 0; 0; 0; 0; 0; 0; 0; 0; -20; 0; 10; 0; 0; 0; 0; 0; 0; 0; 0; 0; -10; 0; 0; 0; 0; 0; 0; 0; 0; 0; 0; 0; -20; 20; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 10; -10; 0; 0; 0; 0; 0; 0; 0; 0; 0; 0; 0; 0; 0; 0; 0; 0; 0; 0; 0; 0; 0; 10; 10; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; -10; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0; 0]

Now, a first inverse transform using $A_2$ is applied on the de-quantization transform signal (shown in **bold** in the de-quantized signal above).

The reconstructed signal for the second divisor is given as:

[2813,07; 2805,41; 2794,59; 2786,93; 2745,77; 2728,88; 2731,12; 2714,23; 2667,62; 3180,34; 2739,66; 2712,38; 2705,00; 2705,00; 2705,00; 2705,00; 2705,00; 2705,00; 2705,00; 2705,00; 2700,00; 2690,00; 2690,00; 2700,00; 2725,76; 2758,83; 2751,17; 2744,24; 2741,53; 2737,71; 2732,29; 2728,47; 2725,00; 2715,00; 2715,00; 2725,00; 2728,11; 2740,35; 2769,65; 2761,89; 2752,30; 2711,59; 2708,41; 2707,70; 2659,67; 2816,14; 3233,86; 2670,33; 2681,53; 2677,71; 2672,29; 2668,47; 2670,00; 2670,00; 2670,00; 2670,00; 2656,53; 2642,71; 2637,29; 2643,47; 2689,23; 2716,12; 2713,88; 2720,77]

Now, the complete reconstructed signal after the second divisor is given as:

[2813,07; 2805,41; 2794,59; 2786,93; 2745,77; 2728,88; 2731,12; 2714,23; 2667,62; 3180,34; 2739,66; 2712,38; 2705,00; 2705,00; 2705,00; 2705,00; 2705,00; 2705,00; 2705,00; 2705,00; 2700,00; 2690,00; 2690,00; 2700,00; 2725,76; 2758,83; 2751,17; 2744,24; 2741,53; 2737,71; 2732,29; 2728,47; 2725,00; 2715,00; 2715,00; 2725,00; 2728,11; 2740,35; 2769,65; 2761,89; 2752,30; 2711,59; 2708,41; 2707,70; 2659,67; 2816,14; 3233,86; 2670,33; 2681,53; 2677,71; 2672,29; 2668,47; 2670,00; 2670,00; 2670,00; 2670,00; 2656,53; 2642,71; 2637,29; 2643,47; 2689,23; 2716,12; 2713,88; 2720,77; 0,00; 10,00; 0,00; 20,00; 0,00; 0,00; 0,00; 20,00; -20,00; - 140,00; 60,00; 0,00; 0,00; 0,00; 10,00; 0,00; 0,00; 0,00; 0,00; 0,00; 0,00; 0,00; 0,00; -10,00; - 10,00; 0,00; 0,00; 0,00; 0,00; 0,00; 10,00; 0,00; 0,00; 0,00; 0,00; 0,00; 0,00; -10,00; 0,00; 0,00; 20,00; 0,00; 0,00; 0,00; 30,00; -190,00; 170,00; 10,00; 0,00; 0,00; 0,00; 0,00; 0,00; 0,00; 0,00; 0,00; 0,00; 0,00; 0,00; -10,00; -10,00; 0,00; 0,00; 0,00; 0,00; 0,00; 0,00; 0,00; 0,00; 0,00; 0,00; 0,00; 40,00; -100,00; 70,00; 0,00; 0,00; 10,00; 0,00; 0,00; 0,00; 0,00; 0,00; 0,00; 0,00; 0,00; -10,00; 0,00; 0,00; 0,00; 0,00; 0,00; 0,00; 0,00; 0,00; 0,00; 0,00; 0,00; 0,00; 0,00; 0,00; -10,00; 0,00; 0,00; 0,00; 0,00; 0,00; -10,00; 40,00; -110,00; 30,00; 0,00; 10,00; -10,00; 0,00; 0,00; 0,00; 0,00; 0,00; 0,00; 0,00; 0,00; 0,00; 0,00; 0,00; 0,00; 0,00; 0,00; 0,00; 0,00; -10,00; 20,00; 40,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; -10,00; 0,00; 0,00; -10,00; 0,00; 0,00; 0,00; 0,00; 0,00; 0,00; 0,00; 0,00; -20,00;

0,00; 10,00; 0,00; 0,00; 0,00; 0,00; 0,00; 0,00; 0,00; 0,00; 0,00; 0,00; 0,00; 0,00; -10,00; 0,00; 0,00; 0,00; 0,00; 0,00; 0,00; 0,00; 0,00; 0,00; 0,00; 0,00; 0,00; -20,00; 20,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 10,00; -10,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 10,00; 10,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; -10,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00; 0,00]

Finally, applying the inverse transform using $A_1$ on the above signal, the reconstructed signal of the original electrocardiogram raw data after performing the final inverse operations is given as:

[994,57; 994,57; 994,57; 994,57; 994,57; 994,57; 994,57; 994,57; 996,77; 996,02; 994,64; 992,84; 990,89; 989,09; 987,71; 986,96; 988,04; 988,04; 988,04; 988,04; 988,04; 988,04; 988,04; 988,04; 995,14; 993,64; 990,89; 987,28; 983,38; 979,77; 977,02; 975,52; 970,78; 970,78; 970,78; 970,78; 970,78; 970,78; 970,78; 970,78; 964,80; 964,80; 964,80; 964,80; 964,80; 964,80; 964,80; 964,80; 965,60; 965,60; 965,60; 965,60; 965,60; 965,60; 965,60; 965,60; 969,43; 967,94; 965,18; 961,58; 957,67; 954,07; 951,31; 949,82; 947,66; 943,46; 934,84; 925,49; 923,84; 936,14; 958,14; 975,59; 1011,68; 1051,92; 1098,28; 1150,40; 1180,51; 1193,73; 1182,03; 1126,80; 1056,85; 991,08; 946,18; 942,25; 944,45; 950,12; 958,80; 959,19; 958,97; 958,97; 958,97; 958,97; 958,97; 958,97; 958,97; 958,97; 956,36; 956,36; 956,36; 956,36; 956,36; 956,36; 956,36; 956,36; 960,98; 958,28; 954,45; 951,74; 951,74; 954,45; 958,28; 960,98; 961,27; 960,52; 959,14; 957,34; 955,39; 953,58; 952,20; 951,46; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 956,36; 954,59; 954,59; 954,59; 954,59; 954,59; 954,59; 954,59; 954,59; 951,06; 951,06; 951,06; 951,06; 951,06; 951,06; 951,06; 951,06; 951,06; 951,06; 951,06; 951,06; 951,06; 951,06; 951,06; 945,07; 948,52; 953,73; 958,24; 960,19; 959,29; 956,84; 954,88; 958,80; 959,54; 960,92; 962,73; 964,68; 966,48; 967,86; 968,61; 975,39; 975,39; 975,39; 975,39; 975,39; 975,39; 975,39; 975,39; 972,69; 972,69; 972,69; 972,69; 972,69; 972,69; 972,69; 972,69; 970,23; 970,23; 970,23; 970,23; 970,23; 970,23; 970,23; 969,28; 969,28; 969,28; 969,28; 969,28; 969,28; 969,28; 969,28; 967,93; 967,93; 967,93; 967,93; 967,93; 967,93; 967,93; 967,93; 970,92; 970,17; 968,79; 966,99; 965,04; 963,23; 961,85; 961,11; 964,66; 964,66; 964,66; 964,66; 964,66; 964,66; 964,66; 964,66; 963,43; 963,43; 963,43; 963,43; 963,43; 963,43; 963,43; 963,43; 955,74; 960,87; 964,80; 962,68; 957,12; 954,99; 958,92; 964,05; 959,90; 959,90; 959,90; 959,90; 959,90; 959,90; 959,90; 959,90; 963,43; 963,43; 963,43; 963,43; 963,43; 963,43; 963,43; 963,43; 960,37; 965,51; 969,44; 967,31; 961,75; 959,63; 963,56; 968,69; 963,96; 964,70; 966,08; 967,88; 969,84; 971,64; 973,02; 973,76; 974,60; 977,31; 981,13; 983,84; 983,84; 981,13; 977,31; 974,60; 976,48; 976,48; 976,48; 976,48; 976,48; 976,48; 976,48; 976,48; 982,89; 981,40; 978,64; 975,04; 971,14; 967,53; 964,77; 963,28; 958,69; 958,69; 958,69; 958,69; 958,69; 958,69; 958,69; 958,69; 957,57; 957,57; 957,57; 957,57; 957,57; 957,57; 957,57; 957,57; 957,31; 957,31; 957,31; 957,31; 957,31; 957,31; 957,31; 957,31; 950,43; 950,89; 950,58; 947,88; 942,03; 933,91; 925,95; 921,00; 916,18; 922,74; 941,50; 967,74; 993,69; 1027,44; 1076,81; 1119,16; 1172,36; 1196,50; 1215,15; 1207,20; 1174,04; 1120,70; 1055,15; 1005,63; 967,02; 953,03; 936,24; 928,44; 932,05; 940,49; 946,66; 948,90; 948,07; 948,07; 948,07; 948,07; 948,07; 948,07; 948,07; 948,07; 951,33; 948,63; 944,80; 942,09; 942,09; 944,80; 948,63; 951,33; 940,18; 942,89; 946,71; 949,42; 949,42; 946,71; 942,89; 940,18; 943,45; 943,45; 943,45; 943,45; 943,45; 943,45; 943,45; 943,45; 943,99; 943,99; 943,99; 943,99; 943,99; 943,99; 943,99; 943,99; 943,99; 943,99; 943,99; 943,99; 943,99; 943,99; 943,99; 943,99; 943,99; 943,99; 943,99; 943,99; 943,99; 943,99; 943,99; 943,99; 943,99; 943,99; 943,99; 943,99; 943,99; 939,23; 939,23; 939,23; 939,23; 939,23; 939,23; 939,23; 939,23; 934,34; 934,34; 934,34; 934,34; 934,34; 934,34; 934,34; 934,34; 932,42; 932,42; 932,42; 932,42; 932,42; 932,42; 932,42; 932,42; 929,70; 930,45; 931,83; 933,63; 935,58; 937,38; 938,76; 939,51; 941,72; 947,60; 952,91; 952,59; 948,98; 948,66; 953,97; 959,85; 960,29; 960,29; 960,29; 960,29; 960,29; 960,29; 960,29; 960,29; 959,50; 959,50; 959,50; 959,50; 959,50; 959,50; 959,50; 959,50; 961,94; 961,94; 961,94; 961,94; 961,94; 961,94; 961,94; 961,94]

As seen above the components of the original raw data signal are similar to the components of the final reconstructed signal, within only a small percentage difference, demonstrating the low loss of the disclosed compression method. More specifically, the achieved compression ratio in this example is 6.7 using an arithmetic entropy coder.

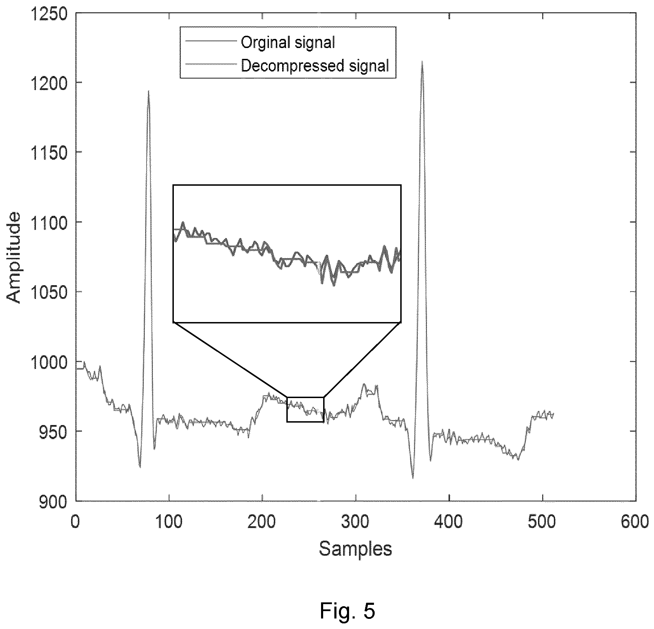

Fig. 5 shows a plot of two curves which is a comparison of the original ECG signal and the resulting signal after compression and decompression according to this example, i.e. a plot of the first and last matrices in the example. Both curves are superposed to a high degree along the whole data length, demonstrating the efficiency of the presently disclosed compression method and the high reliability of the processed signal in comparison with the original signal. A zoom in view of a part of both curves is shown in the center of the plot, in order to highlight the similarity of both raw data and processed data. A noisy-wavy component appears in the raw original data due to measurement uncertainties of the measuring device and the variability of the electrocardiogram itself. The compressed-decompressed signal greatly matches the original raw data, wherein the noisy-wavy component disappears and is transformed into plateaus.

**References**

[1] Liesner Acevedo et al., Partial Data Replication as a Strategy for Parallel Computing of the Multilevel Discrete Wavelet Transform, Parallel Processing and Applied Mathematics, Springer, Berlin Heidelberg, 13 September 2009, pp. 51-60, XP019146926, ISBN: 978-3-642-14389-2.
[2] Hsieh Jui-Hung et al., Wavelet-Based Quality-Constrained ECG Data Compression System Without Decoding Process, IEEE Multimedia, IEEE Service Center, New York, NY, US, vol. 27, no. 2, 31 March 2020, pp. 33-45, XP011793229, DOI: 10.1109/MMUL.2020.2983690, ISSN: 1070-986X.
[3] Lorio F. et al., Analysis of Data Compression Methods for Power Quality Events, IEEE Power Engineering Society General Meeting 2004, IEEE, Piscataway, NJ, USA, 6 June 2004, pp. 504-509, XP010756504, DOI: 10.1109/PES.2004.1372851, ISBN: 978-0-7803-8465-1.
[4] Mark Fontenot, A Wavelets Introduction, Journal of Computing Sciences in Colleges, Consortium for Computing Sciences in Colleges, vol. 17, no. 3, 1 February 2002, pp. 290-296, XP058153688, ISSN: 1937-4771.

**Claims**

1. A computer-implemented method (100) for compression of a signal x of length $N_1$ comprising data, the method comprising the steps of:

   - at least for a first level of decomposition, transforming the signal based on a first sparse matrix $\boldsymbol{A}_1$, of size $N_1 \times N_1$ formed by an invertible matrix $\Phi_{d1}$ of size $d_1 \times d_1$, wherein $d_1$ is a divisor of $N_1$, representing a divisor-based signal decomposition for a first divisor $d_1$ to obtain a first decomposed vector $\boldsymbol{s}_1$ of transformation coefficients, wherein $\boldsymbol{s}_1$ = $\boldsymbol{A}_1\boldsymbol{x}$, and wherein the first vector $\boldsymbol{s}_1$ comprises an initial component $\boldsymbol{v}^1$ and detail components $w_1^1, w_2^1, \dots, w_{d_1-1}^1$, and wherein each row vector of $\Phi_{d1}$ is extended up to a signal length $N_1$ by appending $N_1$ - $d_1$ zeros, and each extended row vector of $\Phi_{d1}$ is shifted by $kd_1$, wherein $k$ = 0, 1, 2, ..., $N_1/d_1$ - 1 (101);
   - at least for a second level of decomposition, transforming the initial component based on a second sparse matrix $\boldsymbol{A}_2$, of size $N_2 \times N_2$, where $N_2 = \frac{N_1}{d_1}$, formed by an invertible matrix $\Phi_{d2}$ of size $d_2 \times d_2$, wherein $d_2$ is a divisor of $N_2$, representing a divisor-based signal decomposition for a second divisor $d_2$, to obtain a second decomposed vector $\boldsymbol{s}_2$ of transformation coefficients wherein $\boldsymbol{s}_2 = \boldsymbol{A}_2\boldsymbol{v}^1$, and wherein the second vector $\boldsymbol{s}_2$ comprises an initial component $\boldsymbol{v}^2$ and detail components $w_1^2, w_2^2, \dots, w_{d_2-1}^2$, and wherein each of the row vector of $\Phi_{d2}$ is extended up to a signal length $N_2$ by appending $N_2$ - $d_2$ zeros, and each extended row vector of $\Phi_{d2}$ is shifted by $kd_2$, wherein $k$ = 0, 1, 2, ..., $N_2/d_2$ - 1 (102);
   - quantizing the transformation coefficients of the second vector of transformation coefficients $\boldsymbol{v}^2$, $w_1^2, w_2^2, \dots, w_{d_2-1}^2$ and detail components of the first vector $w_1^1, w_2^1, \dots, w_{d_1-1}^1$, to obtain a quantized transformation vector (103), and
   - compressing the signal based on the quantized transformation vector (104).

2. The method according to any of the preceding claims, wherein the signal is received from one or more sensors, and wherein the quantized transformation vector of each signal from said one or more sensors is concatenated into a single vector, and wherein entropy coding is applied on the single vector such that the signal from the plurality of sensors are compressed (105).

3. The method according to any of the preceding claims, wherein the initial component $\boldsymbol{v}^1$ functions as a low-pass filter and wherein the detail components $w_1^1, w_2^1, \dots, w_{d_1-1}^1$ function as high-pass filters.

4. The method according to any of the preceding claims, wherein $\Phi_{d1}$ and $\Phi_{d2}$ are provided by discrete cosine bases.

5. The method according to any of the preceding claims, wherein the signal $x$ is a row or a column of an image signal **X** of size $N_1 \times N_1$, and wherein the first level decomposition transforms the image signal **X** according to $\boldsymbol{S_1} = \boldsymbol{A}_1\boldsymbol{X}\boldsymbol{B}_1{}^T$, wherein $\boldsymbol{B}_1$ is a column sparse matrix of size $N_1 \times N_1$ constructed using divisor $d_1$, and wherein the transformation results in $\boldsymbol{S}_1$ being represented by one initial component and $d_1^2 - 1$ detail components.

6. The method according to any of claims 1 to 4, wherein the signal $\boldsymbol{x}$ is one dimension of a multi-dimensional signal, and further comprising the step of applying the first level decomposition using the first sparse matrix on each dimension of the multi-dimensional signal, and applying the second level decomposition using the second sparse matrix on an initial component obtained from the first level decomposition.

7. The method according to claim 6, comprising the step of, for the first level decomposition, applying the first sparse matrix and the third sparse matrix based on divisors $d_{1,1}$ and $d_{1,2}$, on at least a first dimension and a second dimension of the two dimensional signal, respectively and for the second level decomposition, applying the second sparse matrix and the fourth sparse matrix based on divisors $d_{2,1}$ and $d_{2,2}$, on at least a second dimension of the two dimensional signal, respectively.

8. The method according to any of the preceding claims, wherein the quantization is adaptive such that the transformation coefficients can be quantized using one or more thresholds and/or wherein for positive signals the quantization is performed after subtracting a mean value from the initial component.

9. The method according to any one of the preceding claims, wherein the signal is received and compressed in real time.

10. The method according to any one of the preceding claims, wherein the signal is a time-series signal or an image signal.

11. The method according to any of the preceding claims, wherein the signal represents real-time sensor data collected by one or more sensors selected from the group of audio sensor, magnetometer, accelerometer, electrocardiogram sensor, image sensor and photoplethysmography sensor.

12. A computer program for compressing a signal comprising data and having instructions, which, when executed by a processing unit, cause the processing unit to carry out the steps of the method according to any one of the claims 1 - 11.

13. An IoT device, such as a wearable device, autonomous vehicle, smart meter, industrial monitoring device, having multiple sensors, wherein the IoT device comprises a processing unit configured to execute the steps of any one of the claims 1 - 11.

14. The IoT device according to claim 13, further configured to store and/or transmit the compressed data.

15. A signal compression system, the system comprising

    - a memory device; and
    - a compression unit, such as an IoT device according to claim 14,
    wherein the system is configured to execute the steps of any one of claims 1 - 11.

**Patentansprüche**

1. Computerimplementiertes Verfahren (100) zur Kompression eines Signals $x$ der Länge $N_1$, das Daten umfasst, wobei das Verfahren die Schritte umfasst:

    - zumindest für eine erste Zerlegungsebene, Transformieren des Signals basierend auf einer ersten dünnbesetzten Matrix $\boldsymbol{A}_1$ der Größe $N_1 \times N_1$, die durch eine invertierbare Matrix $\Phi_{d1}$ der Größe $d_1 \times d_1$ gebildet wird, wobei $d_1$ ein Teiler von $N_1$ ist, was eine teilerbasierte Signalzerlegung für einen ersten Teiler $d_1$ repräsentiert, um einen ersten zerlegten Vektor $\boldsymbol{s}_1$ von Transformationskoeffizienten zu erhalten, wobei $\boldsymbol{s}_1 = \boldsymbol{A}_1\boldsymbol{x}$ ist, und wobei der erste Vektor $\boldsymbol{s}_1$ eine Anfangskomponente $\boldsymbol{v}^1$ und Detailkomponenten $w_1^1, w_2^1, \dots, w_{d_1-1}^1$ umfasst, und wobei jeder Zeilenvektor von $\Phi_{d1}$ durch Anhängen von $N_1 - d_1$ Nullen auf eine Signallänge $N_1$ erweitert wird, und jeder erweiterte Zeilenvektor von $\Phi_{d1}$ um $kd_1$ verschoben wird, wobei $k=$ 0, 1, 2, ..., $N_1/d_1$ - 1 ist (101);

- zumindest für eine zweite Zerlegungsebene, Transformieren der Anfangskomponente basierend auf einer zweiten dünnbesetzten Matrix $\boldsymbol{A}_2$ der Größe $N_2 \times N_2$, wobei $N_2 = \dfrac{N_1}{d_1}$ ist, die durch eine invertierbare Matrix $\Phi_{d2}$ der Größe $d_2 \times d_2$ gebildet wird, wobei $d_2$ ein Teiler von $N_2$ ist, was eine teilerbasierte Signalzerlegung für einen zweiten Teiler $d_2$ repräsentiert, um einen zweiten zerlegten Vektor $\boldsymbol{s}_2$ von Transformationskoeffizienten zu erhalten, wobei $\boldsymbol{s}_2 = \boldsymbol{A}_2 \boldsymbol{v}^1$ ist, und wobei der zweite Vektor $\boldsymbol{s}_2$ eine Anfangskomponente $v^2$ und Detailkomponenten $w_1^2, w_2^2, \ldots, w_{d_2-1}^2$ umfasst, und wobei jeder Zeilenvektor von $\Phi_{d2}$ durch Anhängen von $N_2 - d_2$ Nullen auf eine Signallänge $N_2$ erweitert wird, und jeder erweiterte Zeilenvektor von $\Phi_{d2}$ um $kd_2$ verschoben wird, wobei $k = $ 0, 1, 2, ..., $N_2/d_2$ - 1 ist (102);

- Quantisieren der Transformationskoeffizienten des zweiten Vektors von Transformationskoeffizienten $v^2, w_1^2, w_2^2, \ldots, w_{d_2-1}^2$ und der Detailkomponenten des ersten Vektors $w_1^1, w_2^1, \ldots, w_{d_1-1}^1$, um einen quantisierten Transformationsvektor zu erhalten (103), und

- Komprimieren des Signals basierend auf dem quantisierten Transformationsvektor (104).

2. Verfahren nach einem der vorhergehenden Ansprüche, wobei das Signal von einem oder mehreren Sensoren empfangen wird, und wobei der quantisierte Transformationsvektor jedes Signals von dem einen oder den mehreren Sensoren zu einem einzigen Vektor verkettet wird, und wobei Entropiekodierung auf den einzigen Vektor angewendet wird, so dass das Signal von der Vielzahl von Sensoren komprimiert wird (105).

3. Verfahren nach einem der vorhergehenden Ansprüche, wobei die Anfangskomponente $v^1$ als Tiefpassfilter fungiert und wobei die Detailkomponenten $w_1^1, w_2^1, \ldots, w_{d_1-1}^1$ als Hochpassfilter fungieren.

4. Verfahren nach einem der vorhergehenden Ansprüche, wobei $\Phi_{d1}$ und $\Phi_{d2}$ durch diskrete Kosinus-Basen bereitgestellt werden.

5. Verfahren nach einem der vorhergehenden Ansprüche, wobei das Signal $\boldsymbol{x}$ eine Zeile oder eine Spalte eines Bildsignals $\boldsymbol{X}$ der Größe $N_1 \times N_1$ ist, und wobei die Zerlegung der ersten Ebene das Bildsignal $\boldsymbol{X}$ gemäß $\boldsymbol{S}_1 = \boldsymbol{A}_1 \boldsymbol{X} \boldsymbol{B}_1^T$ transformiert, wobei $\boldsymbol{B}_1$ eine dünnbesetzte Spaltenmatrix der Größe $N_1 \times N_1$ ist, die unter Verwendung des Teilers $d_1$ konstruiert ist, und wobei die Transformation dazu führt, dass $\boldsymbol{S}_1$ durch eine Anfangskomponente und $d_1^2 - 1$ Detailkomponenten repräsentiert wird.

6. Verfahren nach einem der Ansprüche 1 bis 4, wobei das Signal $\boldsymbol{x}$ eine Dimension eines mehrdimensionalen Signals ist, und das ferner den Schritt des Anwendens der Zerlegung der ersten Ebene unter Verwendung der ersten dünnbesetzten Matrix auf jede Dimension des mehrdimensionalen Signals und das Anwenden der Zerlegung der zweiten Ebene unter Verwendung der zweiten dünnbesetzten Matrix auf eine aus der Zerlegung der ersten Ebene erhaltene Anfangskomponente umfasst.

7. Verfahren nach Anspruch 6, umfassend den Schritt, für die Zerlegung der ersten Ebene, des Anwendens der ersten dünnbesetzten Matrix und der dritten dünnbesetzten Matrix basierend auf Teilern $d_{1,1}$ und $d_{1,2}$ auf mindestens eine erste Dimension bzw. eine zweite Dimension des zweidimensionalen Signals, und für die Zerlegung der zweiten Ebene, des Anwendens der zweiten dünnbesetzten Matrix und der vierten dünnbesetzten Matrix basierend auf Teilern $d_{2,1}$ und $d_{2,2}$ auf mindestens eine zweite Dimension des zweidimensionalen Signals.

8. Verfahren nach einem der vorhergehenden Ansprüche, wobei die Quantisierung adaptiv ist, so dass die Transformationskoeffizienten unter Verwendung eines oder mehrerer Schwellenwerte quantisiert werden können, und/oder wobei für positive Signale die Quantisierung nach dem Subtrahieren eines Mittelwertes von der Anfangskomponente durchgeführt wird.

9. Verfahren nach einem der vorhergehenden Ansprüche, wobei das Signal in Echtzeit empfangen und komprimiert wird.

**10.** Verfahren nach einem der vorhergehenden Ansprüche, wobei das Signal ein Zeitreihensignal oder ein Bildsignal ist.

**11.** Verfahren nach einem der vorhergehenden Ansprüche, wobei das Signal Echtzeit-Sensordaten repräsentiert, die von einem oder mehreren Sensoren gesammelt werden, die aus der Gruppe von Audiosensor, Magnetometer, Beschleunigungsmesser, Elektrokardiogrammsensor, Bildsensor und Photoplethysmographiesensor ausgewählt sind.

**12.** Computerprogramm zum Komprimieren eines Signals, das Daten umfasst und Anweisungen aufweist, die bei Ausführung durch eine Verarbeitungseinheit die Verarbeitungseinheit veranlassen, die Schritte des Verfahrens nach einem der Ansprüche 1-11 auszuführen.

**13.** IoT-Vorrichtung, wie beispielsweise eine tragbare Vorrichtung, ein autonomes Fahrzeug, ein intelligenter Zähler, eine industrielle Überwachungsvorrichtung, die mehrere Sensoren aufweist, wobei die IoT-Vorrichtung eine Verarbeitungseinheit umfasst, die konfiguriert ist, die Schritte nach einem der Ansprüche 1-11 auszuführen.

**14.** IoT-Vorrichtung nach Anspruch 13, die ferner konfiguriert ist, die komprimierten Daten zu speichern und/oder zu übertragen.

**15.** Signalkompressionssystem, wobei das System umfasst

- eine Speichervorrichtung; und
- eine Kompressionseinheit, wie beispielsweise eine IoT-Vorrichtung nach Anspruch 14, wobei das System konfiguriert ist, die Schritte nach einem der Ansprüche 1-11 auszuführen.

**Revendications**

**1.** Procédé (100) mis en œuvre par ordinateur pour la compression d'un signal $x$ de longueur $N_1$ comprenant des données, le procédé comprenant les étapes suivantes :

- au moins pour une décomposition de premier niveau, la transformation du signal sur la base d'une première matrice creuse $A_1$, de taille $N_1 \times N_1$ formée par une matrice inversible $\Phi_{d1}$ de taille $d_1 \times d_1$, où $d_1$ est un diviseur de $N_1$, représentant une décomposition de signal basée sur un diviseur pour un premier diviseur $d_1$ afin d'obtenir un premier vecteur décomposé $s_1$ de coefficients de transformation, où $s_1 = A_1 x$, et dans lequel le premier vecteur $s_1$ comprend une composante initiale $v^1$ et des composantes de détail $w_1^1, w_2^1, \dots, w_{d_1-1}^1$, et dans lequel chaque vecteur ligne de $\Phi_{d1}$ est étendu jusqu'à une longueur de signal $N_1$ en ajoutant $N_1 - d_1$ zéros, et chaque vecteur ligne étendu de $\Phi_{d1}$ est décalé de $kd_1$, où $k = 0, 1, 2, ..., N_1/d_1 - 1$ (101) ;
- au moins pour une décomposition de second niveau, la transformation de la composante initiale sur la base d'une deuxième matrice creuse $A_2$, de taille $N_2 \times N_2$, où $N_2 = \dfrac{N_1}{d_1}$, formée par une matrice inversible $\Phi_{d2}$ de taille $d_2 \times d_2$, où $d_2$ est un diviseur de $N_2$, représentant une décomposition de signal basée sur un diviseur pour un second diviseur $d_2$, afin d'obtenir un second vecteur décomposé $s_2$ de coefficients de transformation où $s_2 = A_2 v^1$, et dans lequel le second vecteur $s_2$ comprend une composante initiale $v^2$ et des composantes de détail $w_1^2, w_2^2, \dots, w_{d_2-1}^2$, et dans lequel chaque vecteur de ligne de $\Phi_{d2}$ est étendu jusqu'à une longueur de signal $N_2$ en ajoutant $N_2 - d_2$ zéros, et chaque vecteur de ligne étendu de $\Phi_{d2}$ est décalé de $kd_2$, où $k = 0, 1, 2, ..., N_2/d_2 - 1$ (102) ;
- la quantification des coefficients de transformation du second vecteur de coefficients de transformation $v^2, w_1^2, w_2^2, \dots, w_{d_2-1}^2$ et des composantes de détail du premier vecteur $w_1^1, w_2^1, \dots, w_{d_1-1}^1$, afin d'obtenir un vecteur de transformation quantifié (103), et
- la compression du signal basée sur le vecteur de transformation quantifié (104).

**2.** Procédé selon l'une quelconque des revendications précédentes, dans lequel le signal est reçu d'un ou de plusieurs capteurs, et dans lequel le vecteur de transformation quantifié de chaque signal provenant desdits un ou plusieurs capteurs est concaténé en un vecteur unique, et dans lequel un codage entropique est appliqué sur le vecteur unique de sorte que le signal provenant de la pluralité de capteurs soit compressé (105).

3. Procédé selon l'une quelconque des revendications précédentes, dans lequel la composante initiale $v^1$ fonctionne comme un filtre passe-bas et dans lequel les composantes de détail $w_1^1, w_2^1, \ldots, w_{d_1-1}^1$ fonctionnent comme des filtres passe-haut.

4. Procédé selon l'une quelconque des revendications précédentes, dans lequel $\Phi_{d1}$ et $\Phi_{d2}$ sont fournis par des bases de cosinus discrètes.

5. Procédé selon l'une quelconque des revendications précédentes, dans lequel le signal $x$ est une ligne ou une colonne d'un signal image $X$ de taille $N_1 \times N_1$, et dans lequel la décomposition de premier niveau transforme le signal image $X$ selon $S_1 = A_1 X B_1^T$, où $B_1$ est une matrice creuse de colonne de taille $N_1 \times N_1$ construite à l'aide du diviseur $d_1$, et dans lequel la transformation a pour résultat que $S_1$ est représenté par une composante initiale et $d_1^2 - 1$ composantes de détail.

6. Procédé selon l'une quelconque des revendications 1 à 4, dans lequel le signal $x$ est une dimension d'un signal multidimensionnel, et comprenant également l'étape d'application de la décomposition de premier niveau à l'aide de la première matrice creuse sur chaque dimension du signal multidimensionnel, et d'application de la décomposition de second niveau à l'aide de la deuxième matrice creuse sur une composante initiale obtenue à partir de la décomposition de premier niveau.

7. Procédé selon la revendication 6, comprenant l'étape, pour la décomposition de premier niveau, d'application de la première matrice creuse et de la troisième matrice creuse basées sur les diviseurs $d_{1,1}$ et $d_{1,2}$, respectivement sur au moins une première dimension et une seconde dimension du signal bidimensionnel, et pour la décomposition de second niveau, d'application de la deuxième matrice creuse et de la quatrième matrice creuse basées sur les diviseurs $d_{2,1}$ et $d_{2,2}$, respectivement sur au moins une seconde dimension du signal bidimensionnel.

8. Procédé selon l'une quelconque des revendications précédentes, dans lequel la quantification est adaptative de sorte que les coefficients de transformation puissent être quantifiés à l'aide d'un ou de plusieurs seuils et/ou dans lequel, pour des signaux positifs, la quantification est réalisée après soustraction d'une valeur moyenne de la composante initiale.

9. Procédé selon l'une quelconque des revendications précédentes, dans lequel le signal est reçu et compressé en temps réel.

10. Procédé selon l'une quelconque des revendications précédentes, dans lequel le signal est un signal de série temporelle ou un signal image.

11. Procédé selon l'une quelconque des revendications précédentes, dans lequel le signal représente des données de capteur en temps réel collectées par un ou plusieurs capteurs choisis parmi le groupe de capteurs audio, de magnétomètres, d'accéléromètres, de capteurs d'électrocardiogramme, de capteurs d'image et de capteurs de photopléthysmographie.

12. Programme informatique pour la compression d'un signal comprenant des données et comportant des instructions qui, lorsqu'elles sont exécutées par une unité de traitement, amènent l'unité de traitement à réaliser les étapes du procédé selon l'une quelconque des revendications 1 à 11.

13. Dispositif IoT, tel qu'un dispositif portable, un véhicule autonome, un compteur intelligent, un dispositif de surveillance industrielle, comportant plusieurs capteurs, dans lequel le dispositif IoT comprend une unité de traitement configurée pour exécuter les étapes selon l'une quelconque des revendications 1 à 11.

14. Dispositif IoT selon la revendication 13, configuré également pour stocker et/ou transmettre les données compressées.

15. Système de compression de signal, le système comprenant

- un dispositif de mémoire ; et
- une unité de compression, telle qu'un dispositif IoT selon la revendication 14, dans lequel le système est configuré pour exécuter les étapes selon l'une quelconque des revendications 1 à 11.

Fig. 1a

Fig. 1b

Fig. 1c

Fig. 2b

Fig. 2a

Fig. 2c

Signal $x$ → Transform $s_1 = A_1 x$ — 101

Matrix $A_1$ for divisor $d_1$

Average Component $v^1$

Detail Components $w_1^1, \dots w_{d_1-1}^1$

Quantization & Zero Truncation

Matrix $A_2$ for divisor $d_2$

Transform $s_2 = A_2 v^1$ — 102

Average Component $v^2$

Detail Components $w_1^2, \dots w_{d_2-1}^2$

Quantization — 103

Quantization

Entropy Coding — 105

Compressed signal $y$ — 104

100

Fig. 3

20

Fig. 4

Fig. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Partial Data Replication as a Strategy for Parallel Computing of the Multilevel Discrete Wavelet Transform. **LIESNER ACEVEDO et al.** Parallel Processing and Applied Mathematics. Springer, 13 September 2009, 51-60
- Wavelet-Based Quality-Constrained ECG Data Compression System Without Decoding Process. **HSIEH JUI-HUNG et al.** IEEE Multimedia. IEEE Service Center, 31 March 2020, vol. 27, 33-45
- Analysis of Data Compression Methods for Power Quality Events. **LORIO F. et al.** IEEE Power Engineering Society General Meeting 2004. IEEE, 06 June 2004, 504-509
- **MARK FONTENOT**. A Wavelets Introduction. *Journal of Computing Sciences in Colleges, Consortium for Computing Sciences in Colleges*, 01 February 2002, vol. 17 (3), 290-296